# EUROPEAN PATENT APPLICATION

(11) **EP 4 822 362 A1**
(43) Date of publication of application: **14.10.2026**
(21) Application number: 25169919.5
(22) Date of filing: 11.04.2025
(51) Int. Cl.: G01R 29/027, G01R 31/317

(54) **A DUTY-CYCLE MONITORING CIRCUIT**

(71) Applicant: NXP USA, Inc., Austin, TX 78735 (US)
(72) Inventor: BELCHEV, Totyo Penchev, 5656AG Eindhoven (NL); SCHEIKOWSKI, Felix Dieter, 5656AG Eindhoven (NL); OSTERLOH, Gerhard, 5656AG Eindhoven (NL)
(74) Representative: Schwarzweller, Thomas

(57) **Abstract**

Aspects of this disclosure are directed to a duty cycle, monitoring circuit for receiving at an input, and monitoring a duty cycle of, a clock signal, and comprising: an averaging circuit, connected to the input and configured to average the received clock signal; a first and second comparators, configured to compare the averaged clock signal with upper and lower thresholds, and to output a firs and secondt error signal in response to the average clock signal exceeding the upper threshold, or being less that the second threshold; a divider circuit connected between a first node and a second node, and configured to generate the upper threshold and the lower threshold at respective first and second intermediate nodes; and a first detector circuit operably coupled between the first node and the input for providing, at the first node, a voltage dependent on a maximum of the received clock signal.

## Description

### FIELD OF THE DISCLOSURE

This present disclosure relates to duty cycle monitoring circuits, and in particular to duty cycle monitoring circuits of a signal, in which the duty cycle of the signal is to be monitored remotely from a location at which the signal is generated.

### BACKGROUND

Duty cycle ("DTC") monitoring circuits are used in a variety of applications. One important, but nonlimiting application is that of measuring a clock signal. For example, high-quality clock signals are important for many electronic circuits, and for some circuits, for instance, in automotive radar circuits, it may be critical to have a very robust and reliable clock signal. In some applications, ensuring that the clock duty cycle remains within certain limits may be essential for proper operation of related circuit elements, such as analog to digital converters (ADC), and ensuring these can operate within required performance parameters such as SNR (signal-to-noise ratio). In such applications, it may be important to be able to monitor possible degradation of the reference clock to the ADC, without introducing additional errors.

Many systems rely on clocks generated in one subsystem, to be used in another system. In such systems, particularly at high frequencies, the clock signals may become degraded between subsystems, for example due to non-zero impedance of interconnect circuits and paths. Moreover, there may be variations between the voltage domains of the subsystem in which the clock is generated and the subsystem in which the clock is to be used.

### SUMMARY

According to a first aspect of the present disclosure, there is provided a duty cycle, DTC, monitoring circuit configured to receive at an input, and monitor a duty cycle of, a received clock signal at an input, and comprising: an averaging circuit, connected to the input and configured to average the received clock signal; a first comparator, configured to compare the averaged clock signal with an upper threshold, and to output a first error signal in response to the average clock signal exceeding the upper threshold; a second comparator, configured to compare the averaged clock signal with a lower threshold, and to output a second error signal in response to the lower threshold exceeding the average clock signal; a divider circuit connected between a first node and a second node, and configured to generate the upper threshold and the lower threshold at respective first and second intermediate nodes; and a first detector circuit operably coupled between the first node and the input and configured to provide, at the first node, a voltage dependent on a maximum of the received clock signal. By making the thresholds dependent on the received clock signal, and in particular on its amplitude, which in turn is generally proportional to the voltage supply from which the clock is generated, rather that the local supply voltage at the DTC monitoring circuit, inaccuracies related to variation in voltage in different voltage domains may be reduced or even eliminated.

In one or more embodiments, the first detector circuit comprises an upper envelope detector. In one or more such embodiments the upper envelope detector comprises a peak detector configured to detect a maximum value of the received clock signal. In such embodiments, the thresholds may thus depend directly on the received signal, and in particular on it's upper peak.

In one or more embodiments the second node is connected to a ground. This may be particularly appropriate where the voltage domain where the clock is generated, and the voltage domain of the DC monitoring circuit, share a common ground.

In one or more embodiments, the DTC monitoring circuit further comprises a second detector circuit operably coupled between the second node and the input and configured to provide, at the second node, a voltage dependent on a minimum of the received clock signal. In one or more such embodiments the second detector circuit comprises a lower envelope detector. The lower envelope detector may comprise a valley detector configured to detect a minimum value of the received signal. Such embodiments may be particularly appropriate, in applications which do not have a common ground level between a voltage domain where the signal is generated, and the voltage domain of the DTC monitoring circuit. Such embodiments may also be useful if the signal is degraded to the extent that a low voltage level of the signal does not reach ground level.

In one or more embodiments the averaging circuit comprises an RC filter. In one or more such embodiments the RC filter comprises a resistor connected between the input, and a respective input of each of the first and second comparators. In one or more embodiments the RC filter comprises a capacitor operably coupled between a ground, and a respective input of each of the first and second comparators.

In one or more embodiments, the DTC monitoring circuit further comprises a local voltage supply circuit configured to provide a supply voltage to the first comparator and the second comparator.

In one or more embodiments the upper threshold is within a range of 54% to 56%. In one or more embodiments the lower threshold is within a range of 44% to 46%. In one or more embodiments the received clock signa has a frequency in a range of 1-3 GHz, in particular 2.56GhZ or 2.87GHz. However, the skilled person will appreciate that the disclosure is not limited thereto, and may be used for lower, or higher frequency distributed clock signals, with appropriate length of the interconnect line, how much the clock gets degraded until it reaches the receiver, the technology node, power budget, components sizing, accuracy requirements, and the like.

In one or more embodiments a shortest electrical path length between the received clock signal, and a clock generation circuit is at least 250µm and may typically be 500µm or greater. However, the skilled person will also appreciate that there is no specific minimum path length, below which the disclosure may not have some beneficial effect. Once again, the effectiveness of the disclosure may depend on how much the clock gets degraded until it reaches the receiver, the technology node, power budget, components sizing, accuracy requirements, and the like.

According to a second aspect of the present disclosure, there is provided a system comprising a clock generation circuit configured to generate a clock signal to be provided at the input as the received clock signal, a DTC monitoring circuit a described above, and a clock interconnect therebetween.

In one or more embodiments the clock interconnect has a path length of at least 500 micrometres. In one or more embodiments, the clock generation circuit has a voltage supply circuit, separate to the local voltage supply circuit.

### BRIEF DESCRIPTION OF THE DRAWINGS

Reference will now be made to the accompanying drawings, wherein:
FIG. 1 illustrates a conventional system including a clock generation circuit remote from a second circuit;
FIG. 2 illustrates a duty cycle circuit according to one or more embodiments;
FIG.3 illustrates the duty cycle circuit according to one or more other embodiments;
FIG.4 shows an illustrative peak detector;
FIG. 5 shows an alternative divider circuit; and
FIG. 6 shows a system including a clock generation circuit remote from a duty cycle monitor, according to one or more embodiments.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION

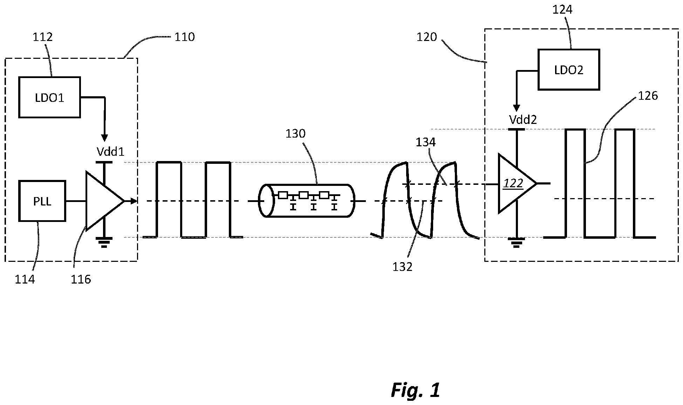

FIG. 1 shows an example system, in which a clock is generated in a first subsystem including a clock generation unit 110, which is remote from a second subsystem, an input stage of which is shown at 120. As used herein "remote" is not limited to separate, distinct integrated circuits, but rather includes application in which the two units are not located adjacent to each other - that is to say they typically occupy separate parts of an integrated circuit, and those parts may be separated by a distance of several tens, and typically hundreds or even thousands, of micrometres. An interconnect 130, which may be for example, a metal track on an integrated circuit, is provided between the two units or subsystems. The clock generation unit 110 operates in a first voltage domain at a first supply voltage Vdd1, which may be provided by a voltage regulator such as a low dropout (LDO) regulator 112. An accurate clock signal may be generated by means of, for example, a phase locked loop (PLL) 114, and buffered by a buffer circuit 116. A 50% duty cycle, clock may thereby be produced in the first subsystem, and transmitted to the second subsystem over the interconnect 130.Due to the finite, nonzero impedance of the interconnect 130, the clock signal may be degraded. In particular, the ideal or nearly ideal square wave generated by the clock generation unit may be rounded, as a result of finite slew rates of the transitions between the high and low value.

The skilled person will be aware that DTC monitors are typically based on converting the clock's duty-cycle into a DC voltage (for instance by using a low pass RC filter. The average (DC) level of a square-wave signal is proportional to its duty cycle, that is to say Vavg = α(Vhigh-Vlow), where α is the duty cycle (between 0% and 100%). Thus, if the average level (Vavg) is midway between the high (Vhigh) and low (Vlow) values, it may be determined that the duty cycle is 50%; this relationship will still generally hold even for degraded clock signal, such as that shown on the receive side of FIG. 1. For clock signals with a nonzero slew time between high and low values, the duty cycle may be defined by the moments at which the signal crosses - rising and falling - the level corresponding to half the peak signal amplitude.

In the instance that there is a variation between the voltage domain of the first subsystem and the voltage domain of the second subsystem, this can result in a modified apparent duty cycle of the clock signal, if logic gates are used at the input, as will now be described. In complex applications such as automotive radar, it is generally to be anticipated that the voltage domain of the second subsystem such as a receiver circuit may use a separate voltage regulator, such as LDO2 124, to that in the first subsystem. As a result, the power supply voltage Vdd2 in the second subsystem may not be the same as the power supply voltage Vdd1 in the first subsystem. A typical logic gate 122 acts on the received signal, and detects a 50% level, to trigger a switch between it's high and low levels, as shown at 126. As can be seen in FIG. 1, provided the "50% level" is midway between the high and low levels of the original clock, as shown at 132, the switching of the logic gate would have the same duty cycle (typically 50%) as the original signal, since the degraded slew rates of the transitions between high and low would generally cancel each other out. However, in the case that Vdd2 is not the same as Vdd1, the 50% level, shown at 134 in FIG. 1, at which the logic gate switches will not match that of the original clock shown at 132. In the example shown, the slew in the low-to-high transition has a greater impact than the slew in the high-to-low transition. This can result, as shown, in an apparent duty cycle which, as shown may be less than 50%, according to the logic gate 122.

In the event that the logic gate 122 is part of a duty cycle monitor, it will result in an incorrect value for the apparent duty cycle of the received signal, and may trigger error events inappropriately. This effect may become more significant with either increasing deviation between the voltages of the two voltage domains provided by the separate regulator, such as LDO1 122 and LDO2 124, or with increasing clock frequency (such that the finite slew has a larger impact).

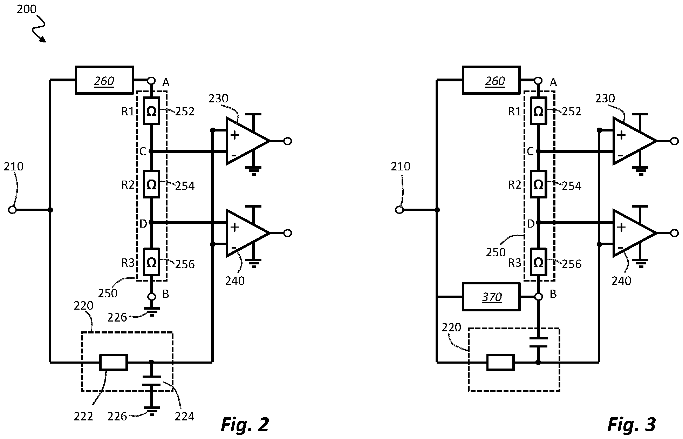

FIG. 2 shows a duty cycle (DTC) monitoring circuit according to one or more embodiments of the present disclosure. The DTC monitoring circuit 200 is configured to receive a received clock signal at an input 210, and monitor the duty cycle of the received clock signal at an input. In order to avoid the potential mismatch between the supply voltage in the local subsystem, and the supply voltage according to which the clock was originally generated, the DTC monitoring circuits uses the clock itself to determine at least one of the high and low levels.

The DTC monitoring circuit of FIG. 2 includes an averaging circuit 210, connected to the input and configured to average the received clock signal. The averaging circuit 220 determines an average value of the clock signal. The average time may be over a fixed period such as a cycle, or may be a longer term average. One, nonlimiting, particularly convenient way of providing the average value is by means of a low pass RC filter circuit as shown. As will be familiar to the skilled person, the low pass RC filter circuit includes a series resistor 222, connected between the averaging circuit's input and output, together with a shunt capacitor 224 connected between the averaging circuits output and a reference which for example may be a ground 226 as shown. The skilled person will appreciate that the average value may be determined and provided by other means as alternatives to the simple 1-pole filter shown above. For example, multiple poles may be realized by adding further RC sections in series.

The DTC monitoring circuit of FIG. 2 further includes a first comparator 230. Comparator 230 is configured to compare the averaged clock signal with an upper threshold, and to output a first error signal in response to the average clock signal exceeding the upper threshold. Thereto, comparator 230 may be implemented as an operational amplifier having a positive input connected to the averaged clock signal - for example at the output of the low pass RC filter 220, and a negative input connected to a voltage indicative of the upper threshold. The output of the operational amplifier provides an error signal, a "high" value of which is indicative of an "over-range" error.

Similarly, the DTC monitoring circuit of FIG. 2 further includes a second comparator 240. Comparator 240 is configured to compare the averaged clock signal with a lower threshold, and to output a second error signal in response to the average clock signal being less than the lower threshold. Thereto, comparator 230 also may be implemented as an operational amplifier having a negative input connected to the averaged clock signal - for example at the output of the low pass RC filter 220, and a positive input connected to a voltage indicative of the lower threshold. The output of the operational amplifier provides an error signal, a "high" value of which is indicative of an "under-range" error.

The DTC monitoring circuit of FIG. 2 further includes a divider circuit 250 connected between first, A, and second, B, nodes. Divider circuit 250 is configured to generate the upper threshold and the lower threshold at respective first, C, and second, D, intermediate nodes. Divider circuit may be conveniently implemented, as shown in FIG. 2, as a series connected string of three resistors R1, 252, R2 254, and R3 256 connected between node A and node B. The voltages V_{C} and V_{D} at intermediate nodes C and D are then related to the voltages V_{A} and V_{B} at nodes A and B through:${V}_{C} = {V}_{B} + \left({V}_{A}-{V}_{B}\right) * \left(R3+R2\right) / \left(R1+R2+R3\right) ,$ and${V}_{D} = {V}_{B} + \left({V}_{A}-{V}_{B}\right) * R 3 / \left(R1+R2+R3\right) .$

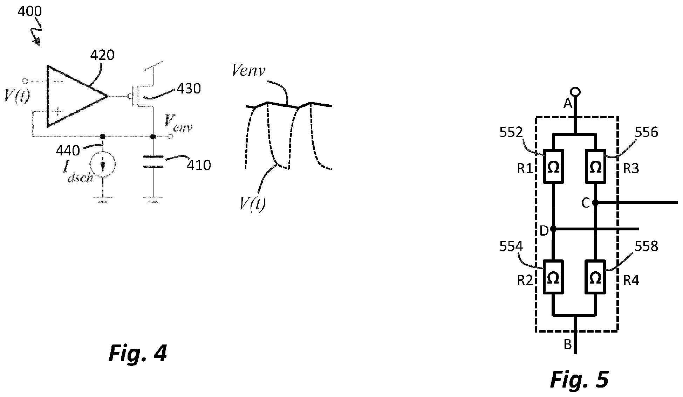

The divider circuit may be implemented in alternative forms. For example, one alternative is to have two parallel subdivider circuits are R1 552 and R2 554, and R3 556 and R4 558, respectively as illustrated in FIG. 5, in which:${V}_{D} = {V}_{B} + \left({V}_{A}-{V}_{B}\right) * R 2 / \left(R1+R2\right) ,$ and${V}_{C} = {V}_{B} + \left({V}_{A}-{V}_{B}\right) * R 4 / \left(R3+R4\right) .$

The DTC monitoring circuit of FIG. 2 further includes a first detector circuit 260 connected between the first node and the input and configured to provide, at the first node, a voltage dependent on a maximum of the received clock signal. Thus, instead of a conventional circuit in which the voltage at node A may be provided from the local power rail Vdd2 (for example through LDO2 of FIG. 1), according to embodiments of the present disclosure, the voltage at node A, corresponding to the top of the divider circuit, is generated from the clock signal itself, and thus is linked to or derived from the voltage domain in which the clock is generated, V_{A} = F{Vdd1}, where F{} indicate a function. For a clock signal which swings between the full voltage rails on Vdd1, and for which the degradation is not sufficient to reduce the maximum voltage: V_{A} ≈ Vdd1. In other words, the voltage used to generate the thresholds is independent of the local supply voltage Vdd2. This removes the dependence of the monitoring circuit on variations between the supply voltages Vdd1 and Vdd2.

In some embodiments the first detector circuit comprises an upper envelope detector. The upper envelope detector may comprise a peak detector configured to detect a maximum value of the received clock signal. The peak detector may be implemented in any one of a variety of circuits, as will be familiar to the skilled person. One, nonlimiting, example of such a peak detector will be described hereinbelow with reference to FIG. 4. The particular implementation used for any DTC monitoring circuit may depend upon the application, and in particular, upon such factors as the signal shape, operating frequency, required position level, available area and power budget or the like.

In embodiments such as that shown in FIG. 2, the second node, B, at the lower voltage of the voltage divider 250 is connected to ground 226. The skilled person will appreciate that this is appropriate for clock signals for which the low value of the clock is at or very near to ground voltage, and there is no, or little, variation in ground between the voltage subdomains. In one or more other embodiments, the second node may be derived from the clock signal itself, in the same way that the voltage at the first node A is derived from the clock signal. This is illustrated in FIG. 3.

FIG. 3 shows a DTC monitor circuit which further comprises a second detector circuit 370 operably coupled between the second node and the input and configured to provide, at the second node, a voltage dependent on a minimum of the received clock signal. The second detector circuit may comprise a lower envelope detector, and the lower envelope detector may comprise a valley detector configured to detect a minimum or valley value of the received clock signal. Use of a second detector circuit to detect a valley or minimum value of the received signal may entirely decouple the thresholds in the DC monitoring circuit from the local voltage domain Vdd2. In other words, such embodiments may be used where the ground value in a receiver circuit is isolated from, or separate to, a ground value in the clock generation circuit. Similarly to the upper envelope detector circuit, the detailed implementation may depend on or be dictated by specific requirements of the use case. However, as a general principle the second detector circuit is used to determine the bottom of the voltage divider, based on a level (that is to say the "low" value of the clock), which applies at the clock generation.

FIG. 4 shows one implementation of an envelope detector circuit 400. The skilled person will appreciate that this is just one possible implementation among many. This circuit is, as shown, a peak detector which is configured to provide an output which corresponds to the peak value of a time-varying input signal V(t). The time-varying signal is the degraded clock signal:$V \left(t\right) = Vlow + \left(Vhigh-Vlow\right) * H \left\{\left(t.mod\left(1/fck\right)\right)-\frac{1}{2}\right\} ,$

where H{ } is the Heaviside step function, fck is the clock frequency). Whenever the time-varying signal exceeds the voltage Venv across the capacitor 410 (as determined by the comparator 420, switch 430 opens to increase the charge on the capacitor, thereby raising Venv, until it reaches the peak value of the time-varying signal (that is to say, in this case, the "high" level of the degraded clock signal). A slow leakage path Idsch 440 is provided to slowly discharge the capacitor 420 so as to accommodate possible changes in the high level.

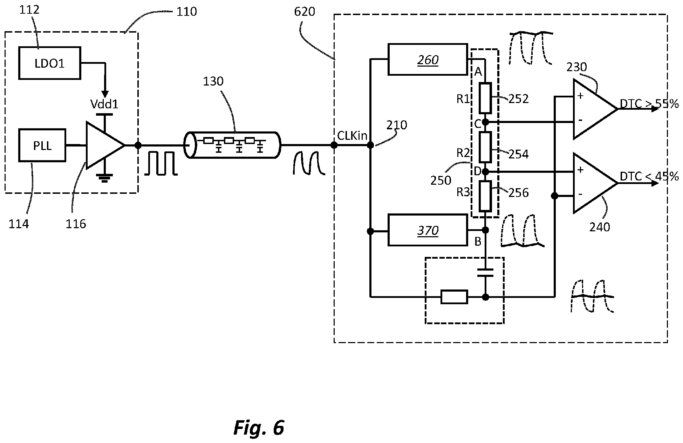

FIG. 6 illustrates a system according to one or more embodiments. Similar to FIG. 1, a clock is generated in a first subsystem including clock generation unit 110, which is remote from a second subsystem, which includes a DTC monitoring circuit at input stage 620. An interconnect 130, is provided between the two subsystems. The clock generation unit 110 operates in a first voltage domain at a first supply voltage Vdd1, which may be provided by a voltage regulator such as a low dropout (LDO) regulator 112. An accurate clock signal may be generated by means of, for example, a phase locked loop (PLL) 114, and buffered by a buffer circuit 116. An accurate, 50% duty cycle, clock may thereby be produced in the first subsystem, and transmitted to the second subsystem over the interconnect 130. The signal may degrade during transmission and is received at the input of the second subsystem CLKin. As described above with reference to FIG. 3, the clock signal is used to determine the upper and lower ends of the voltage divider 250, intermediate values C and D of which are used as threshold values for two comparators 230 240, which may be used to determine over-range, or under-range errors in the duty cycle of the clock signal. Because the voltages at the ends (or at least one end A) of the voltage divider are determined from the clock, rather than the local supply voltage, variations in supply subdomains should not affect the precision or accuracy of the monitoring and error detection.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. A duty cycle, DTC, monitoring circuit (200) configured to receive, at an input (210), and monitor a duty cycle of, a received clock signal, and comprising:
an averaging circuit (220), connected to the input and configured to average the received clock signal;
a first comparator (230), configured to compare the averaged clock signal with an upper threshold, and to output a first error signal in response to the averaged clock signal exceeding the upper threshold;
a second comparator (240), configured to compare the averaged clock signal with a lower threshold, and to output a second error signal in response to the lower threshold exceeding the average clock signal;
a divider circuit (250) connected between a first node and a second node, and configured to generate the upper threshold and the lower threshold at respective first and second intermediate nodes; and
a first detector circuit (260) operably coupled between the first node and the input and configured to provide, at the first node, a voltage dependent on a maximum of the received clock signal.

2. The DTC monitoring circuit of claim 1, wherein the first detector circuit comprises an upper envelope detector.

3. The DTC monitoring circuit of claim 2, wherein the upper envelope detector comprises a peak detector configured to detect a maximum value of the received clock signal.

4. The DTC monitoring circuit any preceding claim wherein the second node is connected to a ground.

5. The DTC monitoring circuit any of claims 1-3, further comprising a second detector circuit (370) operably coupled between the second node and the input and configured to provide, at the second node, a voltage dependent on a minimum of the received clock signal.

6. The DTC monitoring circuit of claim 5, wherein the second detector circuit comprises a lower envelope detector.

7. The DTC monitoring circuit of claim 6, wherein the lower envelope detector comprises a valley detector configured to detect a minimum value of the received clock signal.

8. The DTC monitoring circuit of any preceding claim, wherein the averaging circuit comprises an RC filter.

9. The DTC monitoring circuit of any preceding claim further comprising a local voltage supply circuit configured to provide a supply voltage to the first comparator and the second comparator.

10. The DTC monitoring circuit of any preceding claim, wherein at least one of the upper threshold is within a range of 54% to 56%, and the lower threshold is within a range of 44% to 46%.

11. The DTC monitoring circuit of any preceding claim, wherein the received clock signal has a frequency in a range of 1-3GHz.

12. The DTC monitoring circuit of any preceding claim, wherein a shortest electrical path length between the received clock signal, and a clock generation circuit is at least 250 micrometres.

13. A system comprising a clock generation circuit configured to generate a clock signal to be provided at the input as the received clock signal, the DTC monitoring circuit according to any preceding claim, and a clock interconnect therebetween.

14. The system of claim 16, wherein the clock interconnect has a path length of at least 250 micrometres.

15. The system of claim 16 or 17, in which the DTC monitoring circuit is according to claim 11, wherein the clock generation circuit has a voltage supply circuit, separate to the local voltage supply circuit.

## Amended claims

### Amended claims in accordance with Rule 137(2) EPC.

1. A duty cycle, DTC, monitoring circuit (200) configured to receive, at an input (210), and monitor a duty cycle of, a received clock signal, and comprising:
an averaging circuit (220), connected to the input and configured to average the received clock signal;
a first comparator (230), configured to compare the averaged clock signal with an upper threshold, and to output a first error signal in response to the averaged clock signal exceeding the upper threshold;
a second comparator (240), configured to compare the averaged clock signal with a lower threshold, and to output a second error signal in response to the lower threshold exceeding the average clock signal;
a divider circuit (250) connected between a first node and a second node, and configured to generate the upper threshold and the lower threshold at respective first and second intermediate nodes; and
a first detector circuit (260) operably coupled between the first node and the input and configured to provide, at the first node, a voltage dependent on a maximum voltage of the received clock signal.

2. The DTC monitoring circuit of claim 1, wherein the first detector circuit comprises an upper envelope detector.

3. The DTC monitoring circuit of claim 2, wherein the upper envelope detector comprises a peak detector configured to detect a maximum value of the received clock signal.

4. The DTC monitoring circuit any preceding claim wherein the second node is connected to a ground.

5. The DTC monitoring circuit any of claims 1-3, further comprising a second detector circuit (370) operably coupled between the second node and the input and configured to provide, at the second node, a voltage dependent on a minimum voltage of the received clock signal.

6. The DTC monitoring circuit of claim 5, wherein the second detector circuit comprises a lower envelope detector.

7. The DTC monitoring circuit of claim 6, wherein the lower envelope detector comprises a valley detector configured to detect a minimum value of the received clock signal.

8. The DTC monitoring circuit of any preceding claim, wherein the averaging circuit comprises an RC filter.

9. The DTC monitoring circuit of any preceding claim further comprising a local voltage supply circuit configured to provide a supply voltage to the first comparator and the second comparator.

10. The DTC monitoring circuit of any preceding claim, wherein at least one of the upper threshold is within a range of 54% to 56%, and the lower threshold is within a range of 44% to 46%.

11. The DTC monitoring circuit of any preceding claim, wherein the received clock signal has a frequency in a range of 1-3GHz.

12. The DTC monitoring circuit of any preceding claim, wherein a shortest electrical path length between the received clock signal, and a clock generation circuit is at least 250 micrometres.

13. A system comprising a clock generation circuit configured to generate a clock signal to be provided at the input as the received clock signal, the DTC monitoring circuit according to any preceding claim, and a clock interconnect therebetween.

14. The system of claim 13, wherein the clock interconnect has a path length of at least 250 micrometres.

15. The system of claim 13 or 14, in which the DTC monitoring circuit is according to claim 11, wherein the clock generation circuit has a voltage supply circuit, separate to the local voltage supply circuit.
